# EUROPEAN PATENT APPLICATION

(11) **EP 2 688 103 A1**
(43) Date of publication of application: **22.01.2014**
(21) Application number: 12290246.3
(22) Date of filing: 20.07.2012
(51) Int. Cl.: H01L 27/22, G11C 11/15

(54) **MRAM cell and device with improved field line for reduced power consumption**

(71) Applicant: Crocus Technology S.A., 38025 Grenoble Cedex (FR)
(72) Inventor: Alvarez-Hérault, Jérémy, 38000 Grenoble (FR); Lombard Lucien, 38000 Grenoble (FR)
(74) Representative: P&TS SA (AG, Ltd.)

(57) **Abstract**

Magnetic Random Access Memory (MRAM) cell (1) comprising: a magnetic tunnel junction (2) containing a first ferromagnetic layer (21) having a first magnetization than can be switched in a magnetic field (42), a second ferromagnetic layer (23) having a second magnetization, and a barrier layer (22) between the first and second ferromagnetic magnetic layers (21, 23); a field line (4) being operatively coupled with the MRAM cell (1) and comprises a first portion (4') arranged at one end of the magnetic tunnel junction (2) for passing a field current (41) in a first direction, and a second portion (4") arranged at the other end of the magnetic tunnel junction (2) for passing the field current (41) in a second direction opposed to the first direction, the field current (41) being adapted for generating said magnetic field (42); the first and second portions (4', 4") of the field line (4) being electrically connected in series. The MRAM cell has reduced power consumption.

## Description

### Field

The present disclosure relates to the field of magnetic random access memory (MRAM) cells based on magnetic tunnel junctions and an improvement of the field line in order to reduce the power consumption. The present disclosure also pertains to MRAM devices comprising a plurality of the MRAM cells.

### Description of related art

MRAM-based devices have been the object of a renewed interest with the discovery of magnetic tunnel junctions having a strong magnetoresistance at ambient temperature. These MRAM-based devices present many advantages such as speed (a few nanoseconds of duration of writing and reading), non-volatility, and insensitivity to ionizing radiations. Consequently, they are increasingly replacing memory that uses more conventional technology based on the charge state of a capacitor (DRAM, FLASH).

Conventional MRAM-based devices comprise MRAM cells containing a magnetic tunnel junction, formed from an insulating layer disposed between a ferromagnetic reference layer and a storage layer. A field line is in communication with the ferromagnetic storage layer and a current line is in communication with the ferromagnetic reference layer. The MRAM cell further comprises a CMOS transistor, electrically connected to the magnetic tunnel junction, and which opening and closing allows for addressing each MRAM cell in the MRAM device individually.

During a thermally assisted (TAS) write operation, the transistor is set in a passing mode and a heating current is passed in magnetic tunnel junction via the current line such as to heat the magnetic tunnel junction to a high temperature. A field current is then passed in the field line such as to generate a magnetic field adapted to switch the magnetization of the storage layer of the heated magnetic tunnel junction.

However, most of MRAM devices (standard MRAM, Toggle, TAS-MRAM) suffer from increasing power consumption when the size of the MRAM cell is reduced, for example, when increasing the density of MRAM cells in the MRAM device. For MRAM cells of small cell dimensions (typically below 100 nm), the field current can be high, resulting in high power consumption of the MRAM device.

### Summary

The present disclosure concerns a MRAM cell comprising: a magnetic tunnel junction containing a first ferromagnetic layer having a first magnetization than can be switched in a magnetic field, a second ferromagnetic layer having a second magnetization, and a barrier layer between the first and second ferromagnetic magnetic layers; a field line being operatively coupled with the MRAM cell and comprises a first portion arranged at one end of the magnetic tunnel junction for passing a field current in a first direction, and a second portion arranged at the other end of the magnetic tunnel junction for passing the field current in a second direction opposed to the first direction, the field current (being adapted for generating said magnetic field.

The present disclosure also pertains to a MRAM device, comprising a plurality of the MRAM cells, field lines being operatively coupled with said plurality of MRAM cells, wherein each field line comprises a first portion arranged at one end of the magnetic tunnel junction of the MRAM cells for passing a field current in a first direction, and a second portion arranged at the other end of the magnetic tunnel junction of the MRAM cells for passing the field current in a second direction opposed to the first direction, the field current being adapted for generating said magnetic field.

The MRAM cell, and thus the MRAM device, has reduced power consumption.

### Brief Description of the Drawings

The disclosure will be better understood with the aid of the description of an embodiment given by way of example and illustrated by the figures, in which:
Fig. 1 illustrates a MRAM cell comprising a field line, according to an embodiment;
Figs. 2a and 2b represent a MRAM device comprising a plurality of the MRAM cell and a plurality of the field lines, according to an embodiment; and
Fig. 3 illustrates the MRAM cell comprising the field line, according to another embodiment.

### Detailed Description of possible embodiments

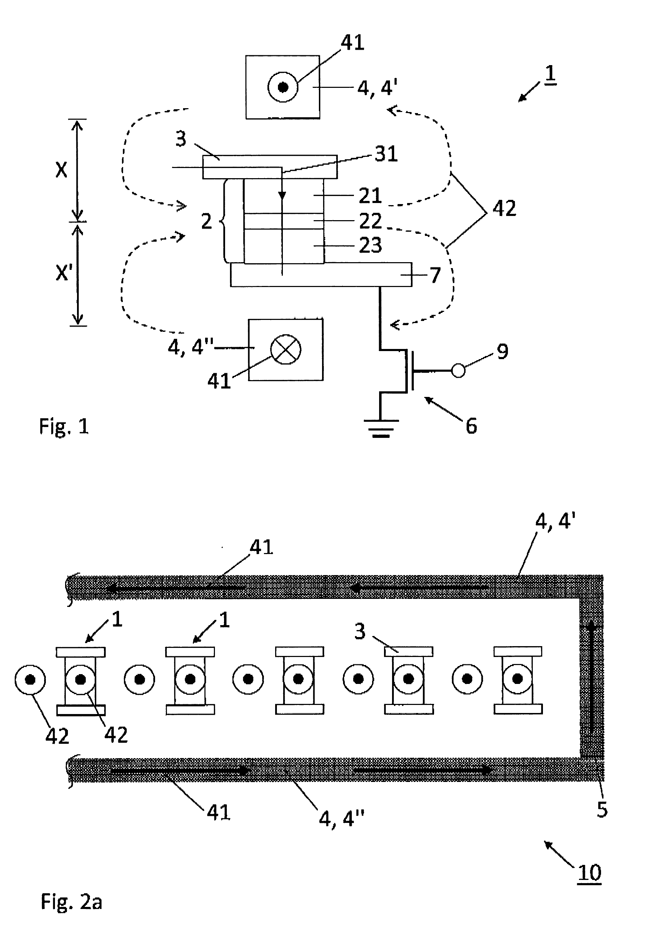

Fig. 1 illustrates a magnetic random access memory (MRAM) cell 1, according to an embodiment. The MRAM cell 1 comprises a magnetic tunnel junction 2 formed from a first ferromagnetic layer 21 having a first magnetization than can be switched in a magnetic field 42, a second ferromagnetic layer 23 having a second magnetization, and an barrier layer 22 being disposed between the first and second ferromagnetic layers 21, 23. The MRAM cell 1 further comprises a field line 4 in communication with the magnetic tunnel junction 2.

The field line 4 comprises a first portion 4' arranged at one end of the magnetic tunnel junction 2, here shown on the side of the first ferromagnetic layer 21, and a second portion 4" arranged at the other end of the magnetic tunnel junction 2, here shown on the side of the second ferromagnetic layer 23. In the example of Fig. 1, the first and second portions 4', 4" are represented orthogonal to the page. The first portion 4' is arranged for passing a field current 41 in a first direction (exiting the page in the example of Fig. 1). The second portion 4" arranged at the other end of the magnetic tunnel junction 2 for passing the field current 41 in a second direction, opposed to the first direction (entering the page in the example of Fig. 1). The field current 41 is such as to generate the magnetic field 42 capable of switching the first magnetization of the first ferromagnetic layer 21. The magnetic field 42 generated by the first and second portions 4', 4" is represented by the dotted arrows in Fig. 1. As can be seen, the magnetic field 42 generated by the field current 41 in the first portion 4' adds to the one generated by the field current 41 in the second portion 4".

The MRAM cell 1 can further comprise a current line 3 in electrical communication with the magnetic tunnel junction 2 (on the side of the first ferromagnetic layer 21). The current line 3 is arranged for passing a heating current 31 in magnetic tunnel junction 2 such as to heat the magnetic tunnel junction 2 during the switching of the first magnetization. Such arrangement is typical of a thermally-assisted (TAS) writable -MRAM cell.

The MRAM cell 1 can further comprise a CMOS selection transistor 6 electrically coupled with the magnetic tunnel junction 2, for example, via a strap 7 connected to the magnetic tunnel junction 2 on the side of the second layer 23. The selection transistor 6 is selectable, For example by a word line 9, such as to be set in a passing mode allowing the heating current 31 to pass in the magnetic tunnel junction 2, or in a blocked mode where no current is able to pass in the magnetic tunnel junction 2.

The scope of the present disclosure is however not limited to a TAS writable MRAM cell but also concerns other types of MRAM cells such as toggle MRAM cells. In the latter case, the current line 3 is adapted for passing a field current for generating a magnetic field.

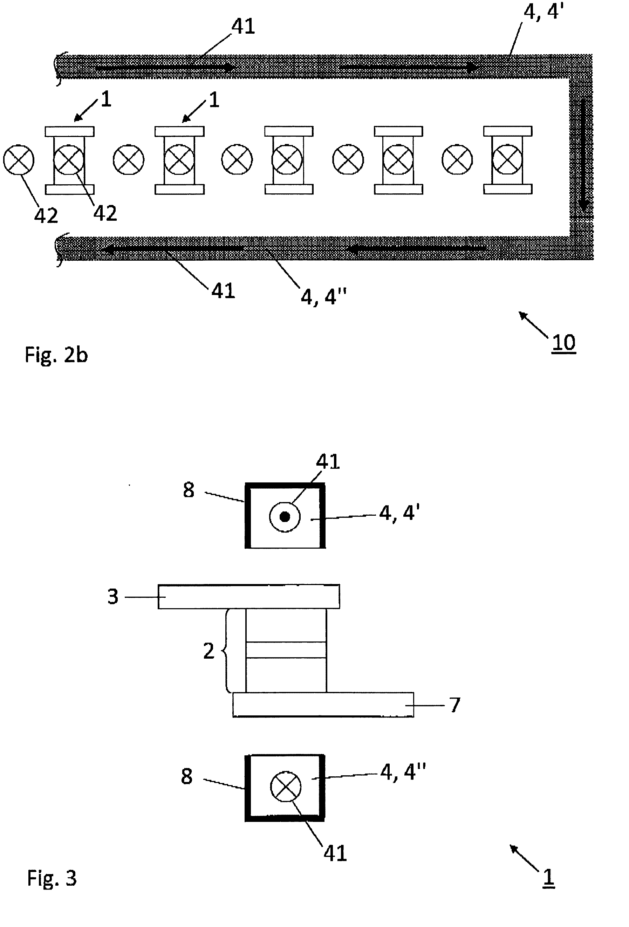

Fig. 2 represents a MRAM device 10 according to an embodiment. The MRAM device 10 comprises a plurality of the MRAM cell 1 and a plurality of the field lines 4 being operatively coupled with the plurality of MRAM cells 1. The plurality of MRAM cells 1 can be arranged in an array of rows and columns. In particular, Fig. 2 shows MRAM cells 1 arranged in a row wherein the first portion 4' is arranged at one end of the magnetic tunnel junction 2, for example on the side of the first ferromagnetic layer 21, and wherein the second portion 4' is arranged at the other end of the magnetic tunnel junction 2, for example on the side of the second ferromagnetic layer 23.

In an embodiment, each of the field lines 4 is arranged such as to be operatively coupled with MRAM cells 1 in one row. Such a configuration of the MRAM device 10 is shown in Figs. 2a and 2b. More particularly, in the configuration of Figs. 2a and 2b, the first and second portions 4', 4" of the field line 4 extend along the row of MRAM cells 1. The first and second portions 4', 4" are further connected in series by a conductive branch 5 extending between the one end and the other end of the MRAM cell 1, at one end of the row, such that the field line 4 is U-shaped. In this configuration, the direction of the field current 41 flowing along the field line 4 is opposed between the first portion 4' and the second portion 4". In Fig. 2a, the field current 41 is represented flowing towards the left and the right in the first and second portions, respectively, such that the magnetic field 42 generated by the filed current 41 exits the page. In Fig. 2b, the field current 41 is represented flowing towards the right and the left in the first and second portions, respectively, such that the magnetic field 42 generated by the filed current 41 enter the page. In this configuration, the magnetic field 42 generated by the first and second portions 4', 4" can switch the first magnetization of said MRAM cells 1 in the row.

In another embodiment not represented, the first and second portions 4', 4" of the field line 4 are operatively coupled with the MRAM cells 1 in two adjacent rows. In such configuration, the magnetic field 42 generated by the first and second portions 4', 4" can switch the first magnetization of said MRAM cells 1 in the two adjacent rows.

In yet another embodiment shown in Fig. 3, the first and second portions 4', 4" of the field line 4 comprise a cladding 8. More particularly, the cladding can comprise a cladding layer 8 formed on three sides of the field line 4 (U-shaped cladding) or on one side of the field line 4. In the latter case, said one cladding layer can be on the side of the first and second portions 4', 4" being opposed to the magnetic tunnel junction 2, such that the MRAM cell 1 is comprised between said one cladding layers of the first and second portions 4', 4". The cladding 8 concentrates further the magnetic field 42 in the region of the magnetic tunnel junction 2.

The MRAM device 10 can further comprise current lines 3 in electrical communication with the MRAM cells 1, wherein each current line 3 is adapted for passing the heating current 31 in the plurality of MRAM cells 1. In the example of Figs 1 and 2, the current lines 3 are represented perpendicular to the field line 4. Other configurations of the current line 4 and current line 7 are however possible. For example, the current lines 3 could be connected at the one end of the magnetic tunnel junction 2 on the side of the first ferromagnetic layer 21.

In the configuration of the MRAM device 10 as disclosed herein, the field line 4 comprising the first and second portions 4', 4" has a length that can be at least twice the length of a field line that would comprise only one of the first and second portions 4', 4". The magnitude of the magnetic field 42 generated by the field current 41 passing in the first and second portions 4', 4" corresponds substantially to the sum of the of the magnetic field being generated by the individual first and second portions 4', 4". In the case the distance X between the magnetic tunnel junction 2 and the first portion 4' is equal to the distance X' between the magnetic tunnel junction 2 and the second portion 4", the magnitude of the magnetic field 42 generated by the field current 41 passing in the first and second portions 4', 4" is substantially twice the magnitude of the magnetic field 42 that would be generated by only one of the portion 4', 4". In Figs 2a and 2b, the magnetic field 42 is represented schematically by the symbol representing an arrow that is coming out of the page and by the symbol representing an arrow that is going into the page, respectively. The configuration of the MRAM device 10 thus results in an increased magnitude of the magnetic field 42 for the same intensity of the field current 41, while the density of the MRAM device 10 (and MRAM cell 1) remains substantially the same as the one of a conventional MRAM device.

As discussed above, the distance X and X' between the center of the magnetic tunnel junction 2 and the first and second portions 4', 4", respectively does not need to be equal. What is important here, is the increase in the magnitude of the magnetic field 42 due to the contribution of the field current 41 passing in the first and second portions 4', 4".

An advantage of the field line 42 comprising the first and second portions 4', 4" is that the MRAM cell 1, and thus the MRAM device 10, can have reduced power consumption.

The MRAM device 10 comprising the field line 42 having the first and second portions 4', 4" can be used for any MRAM-based devices using field lines, for instance standard MRAMs, Toggle MRAM, TAS-MRAM, and self-referenced TAS-MRAM.

### Reference numbers

- 1: magnetic random access memory (MRAM) cell
- 2: magnetic tunnel junction
- 21: first ferromagnetic layer
- 22: barrier layer
- 23: second ferromagnetic layer
- 3: current line
- 4: field line
- 4': first portion of field line
- 4": second portion of field line
- 5: conductive branch
- 6: selection transistor
- 7: strap
- 8: cladding
- 9: word line
- X, X': distance

## Claims

1. Magnetic Random Access Memory (MRAM) cell (1) comprising
a magnetic tunnel junction (2) containing a first ferromagnetic layer (21) having a first magnetization than can be switched in a magnetic field (42), a second ferromagnetic layer (23) having a second magnetization, and a barrier layer (22) between the first and second ferromagnetic layers (21, 23);
a field line (4) being operatively coupled with the MRAM cell (1) and comprises a first portion (4') arranged at one end of the magnetic tunnel junction (2) for passing a field current (41) in a first direction, and a second portion (4") arranged at the other end of the magnetic tunnel junction (2) for passing the field current (41) in a second direction opposed to the first direction, the field current (41) being adapted for generating said magnetic field (42); the first and second portions (4', 4") of the field line (4) being electrically connected in series.

2. MRAM cell (1) according to claim 1, wherein
the first and second portions (4', 4") of the field line (4) comprise a cladding (8).

3. MRAM cell (1) according to claim 1 or 2, further comprising a current line (3) in electrical communication with the magnetic tunnel junction (2).

4. MRAM device (10) according to any one of claims 1 to 3,
wherein
a distance (X) between the center of the magnetic tunnel junction (2) and the first portion (4') and a distance (X') between the center of the magnetic tunnel junction (2) and the second portion (4") is about 1 µm or below.

5. MRAM device (10) according to any one of claims 1 to 3,
wherein
the distance (X, X') between the center of the magnetic tunnel junction (2) and the first and second portions (4', 4") is about 500 nm or below.

6. MRAM device (10) according to claim 4 or 5, wherein
the distance (X) between the center of the magnetic tunnel junction (2) and the first portion (4') is substantially equal to the distance (X') between the center of the magnetic tunnel junction (2) and the second portion (4"),

7. Magnetic Random Access Memory (MRAM) device (10), comprising:
a plurality of MRAM cells (1), each of the MRAM cell (1) comprising a magnetic tunnel junction (2) containing a first ferromagnetic layer (21) having a first magnetization than can be switched in a magnetic field (42), a second ferromagnetic layer (23) having a second magnetization, and a barrier layer (22) between the first and second ferromagnetic magnetic layers (21, 23);
field lines (4) being operatively coupled with said plurality of MRAM cells (1), wherein each field line (4) comprises a first portion (4') arranged at one end of the magnetic tunnel junction (2) of the MRAM cells (1) for passing a field current (41) in a first direction, and a second portion (4") arranged at the other end of the magnetic tunnel junction (2) of the MRAM cells (1) for passing the field current (41) in a second direction opposed to the first direction, the field current (41) being adapted for generating said magnetic field (42); the first and second portions (4', 4") of the field line (4) being electrically connected in series.

8. MRAM device (10) according to claim 7, wherein
the plurality of MRAM cells (1) is arranged in an array of rows and columns, and wherein said first and second portions (4', 4") of the field line (4) are operatively coupled with MRAM cells (1) in one or more rows.

9. MRAM device (10) according to claim 8, wherein
said first and second portions (4', 4") of the field line (4) are operatively coupled with MRAM cells (1) in one row, such that said magnetic field (42) generated by the first and second portions (4', 4") can switch the first magnetization of said MRAM cells (1) in one row.

10. MRAM device (10) according to claim 8, wherein
said first and second portions (4', 4") of the field line (4) are operatively coupled with MRAM cells (1) in two adjacent rows, such that said magnetic field (42) generated by the first and second portions (4', 4") can switch the first magnetization of said MRAM cells (1) in two adjacent rows.

11. MRAM device (10) according to any one of claims 7 to 10,
wherein
each of the field lines (4) is U-shaped.

12. MRAM device (10) according to any one of claims 7 to 11,
wherein
the first and second portions (4', 4") of the field line (4) comprise a cladding (8).

13. MRAM device (10) according to any one of claims 7 to 12,
further comprising current lines (3) in electrical communication with said plurality of MRAM cells (1), each current line (3) being adapted for passing a heating current (31) in said plurality of MRAM cells (1).

14. MRAM device (10) according to any one of claims 7 to 13, used for Toggle MRAM, thermally-assisted (TAS)-MRAM, or self-referenced TAS-MRAM.
